# EUROPÄISCHE PATENTSCHRIFT

(11) **EP 2 305 016 B1**
(45) Veröffentlichungstag und Bekanntmachung des Hinweises auf die Patenterteilung: **15.05.2013**
(21) Anmeldenummer: 09777867.4
(22) Anmeldetag: 13.08.2009
(51) Int. Cl.: G06F 1/20, H05K 7/20

(54) **FLUGZEUGSIGNALRECHNERSYSTEM MIT EINER MEHRZAHL VON MODULAREN SIGNALRECHNEREINHEITEN**
AIRCRAFT SIGNAL COMPUTER SYSTEM HAVING A PLURALITY OF MODULAR SIGNAL COMPUTER UNITS
SYSTÈME DE CALCULATEUR DE SIGNAUX D'AVION DOTÉ D'UNE PLURALITÉ D'UNITÉS MODULAIRES DE CALCULATEUR DE SIGNAUX

(30) Priorität: 27.08.2008 DE 102008044645; 27.08.2008 US 92103 P
(43) Veröffentlichungstag der Anmeldung: 06.04.2011
(73) Patentinhaber: Airbus Operations GmbH, 21129 Hamburg (DE)
(72) Erfinder: ROERING, Sebastian, 20359 Hamburg (DE)
(74) Vertreter: Schicker, Silvia
(86) Internationale Anmeldenummer: PCT/EP2009/005884
(87) Internationale Veröffentlichungsnummer: WO 2010/022863

(56) Entgegenhaltungen:
- DE-A1- 2 354 260
- GB-A- 2 211 360
- US-A1- 2003 000 721
- US-A1- 2005 068 728

## Beschreibung

Die Erfindung betrifft ein zum Einsatz in einem Flugzeug vorgesehenes Flugzeugsignalrechnersystem, das eine Mehrzahl von modularen Signalrechnereinheiten umfasst.

An Bord eines Flugzeugs unter anderem zur Steuerung sicherheitsrelevanter Funktionen, wie zum Beispiel des Autopilotsystems oder des Flight Management Systems eingesetzte Signalrechnersysteme werden derzeit luftgekühlt. Die Luftkühlung kann entweder durch freie Konvektion oder durch Zwangsbelüftung realisiert werden. Während sich bei der freien Konvektion eine Kühlluftströmung lediglich aufgrund lokaler Dichteunterschiede der Luft einstellt, werden bei der Zwangsbelüftung zusätzliche Gebläse eingesetzt, um den zu kühlenden Signalrechnern von der Flugzeugklimaanlage bereitgestellte Kühlluft zuzuführen. Die Zwangsbelüftung ermöglicht die Abfuhr größerer Wärmemengen von den zu kühlenden Signalrechnern als die freie Konvektion. Allerdings erhöhen die für die Zwangsbelüftung notwendigen Gebläse das Gewicht des Flugzeugs und erzeugen zusätzlich abzuführende Wärmeleistung. Mit den Gebläsen werden zudem zusätzliche mechanische Komponenten in das Flugzeug eingebracht. Dadurch wird die Ausfallwahrscheinlichkeit der Kühlung erhöht.

Ein weiterer Nachteil der gegenwärtig eingesetzten luftgekühlten Signalrechner besteht darin, dass die Rechner zur Sicherstellung einer ordnungsgemäßen Wärmeabfuhr von den Rechnern nach einem Kühlstandard konzipiert werden müssen. Dieser Kühlstandard legt eine maximale Wärmeabgabe bezogen auf ein normiertes Gerätegehäusevolumen fest. Mit anderen Worten, der Kühlstandard schreibt für eine von einem Signalrechner erzeugte und an die Umgebung abzuführende Wärmemenge ein Mindestgerätegehäusevolumen bzw. eine Mindestkontaktoberfläche des Gerätegehäuses mit der Umgebungsluft vor. Das Erfordernis, den Kühlstandard einzuhalten, begrenzt somit die Möglichkeit, die Signalrechner kompakter und leistungsstärker zu bauen.

Für die Kühlung von Leistungselektronik ist es bekannt, Flüssigkeitswärmetauscher, wie beispielsweise Cold Plates zu verwenden. Diese Flüssigkeitswärmetauscher sind hinsichtlich ihres Aufbaus exakt auf die geometrischen Maße der zu kühlenden elektronischen Einrichtung abgestimmt und werden so nahe wie möglich an der Wärmeleistung abgebenden elektronischen Einrichtung positioniert. Beispielsweise können Cold Plates in Zwischenräumen der zu kühlenden elektronischen Einrichtung angeordnet werden. Flüssigkeitskühlsysteme sind für den Abtransport großer Wärmemengen sehr viel besser geeignet als Gas- bzw. Luftkühlsysteme. Allerdings ist es bei einem Cold Plates umfassenden Flüssigkeitskühlsystem erforderlich, für jede Cold Plate zwei separate, mit einem entsprechenden Kälteträgerkreislauf verbundene Kühlmittelanschlüsse vorzusehen. Die Montage und insbesondere die Wartung eines Cold Plate-Flüssigkeitskühlsystems ist daher sehr aufwändig. Darüber hinaus steigt die Wahrscheinlichkeit einer Kühlmittelleckage aufgrund der zusätzlich erforderlichen Kühlmittelanschlüsse mit jeder in dem Kühlsystem vorhandenen Cold Plate an, wodurch unter Umständen die Verfügbarkeit der elektronischen Einrichtung herabgesetzt wird. Ein weiterer Nachteil bekannter Leistungselektronik-Flüssigkeitskühlsysteme besteht darin, dass derzeitige Kühlmittelkupplungen den Differenzdruck im Kälteträgerkreislauf erhöhen. Dies verringert die Effizienz der Flüssigkeitskühlung, da eine erhöhte Pumpleistung erforderlich ist, um die Kälteträgerflüssigkeit durch den Kälteträgerkreislauf zu fördern.

Dokument GB 2 221 360 A offenbart ein Flugzeugsignalrechnersystem mit Signalrechnereinheiten, die jeweils in einem Gehäuse angeordnet sind, und einer Kälteträgerleitung, die mit Auβerflächen der Gehäuse in thermischen Kontact steht.

Die Erfindung ist auf die Aufgabe gerichtet, ein leistungsstarkes, kompakt aufgebautes und effizient gekühltes Flugzeugsignalrechnersystem bereitzustellen.

Diese Aufgabe wird durch ein im Patentanspruch 1 definiertes Flugzeugsignalrechnersystem gelöst.

Das erfindungsgemäße Flugzeugsignalrechnersystem umfasst eine Mehrzahl von modularen Signalrechnereinheiten und eine Flüssigkeitskühleinrichtung zum Kühlen der modularen Signalrechnereinheiten. Die Flüssigkeitskühleinrichtung umfasst eine Kälteträgerleitung, die mit einem zentralen Flüssigkeitskühlsystem eines Flugzeugs verbindbar ist, um der Flüssigkeitskühleinrichtung ein flüssiges Kälteträgermedium mit einer gewünschten tiefen Temperatur zuzuführen. Aufgrund der Verbindung der Kälteträgerleitung der Flüssigkeitskühleinrichtung mit dem zentralen Flugzeugflüssigkeitskühlsystem muss die Flüssigkeitskühleinrichtung nicht mit einer separaten Kältemaschine versehen sein, sondern kann von dem zentralen Flüssigkeitskühlsystem des Flugzeugs mit Kühlenergie versorgt werden. Durch den Verzicht auf eine separate Kältemaschine können Gewichts- und Einbauraumersparnisse realisiert werden. Die Kälteträgerleitung der Flüssigkeitskühleinrichtung kann unmittelbar mit einem Kälterträgerkreislauf des zentralen Flugzeugflüssigkeitskühlsystems in Verbindung stehen, so dass der Kälteträgerleitung der Flüssigkeitskühleinrichtung den Kälterträgerkreislauf des zentralen Flugzeugflüssigkeitskühlsystems durchströmendes Kälteträgermedium zugeführt werden kann. Zur Steuerung der Zufuhr des Kälteträgermediums aus dem Kälterträgerkreislauf des zentralen Flugzeugflüssigkeitskühlsystems in die Kälteträgerleitung der Flüssigkeitskühleinrichtung und/oder zur Steuerung der Abfuhr des Kälteträgermediums aus der Kälteträgerleitung der Flüssigkeitskühleinrichtung in den Kälterträgerkreislauf des zentralen Flugzeugflüssigkeitskühlsystems können beispielsweise entsprechende Ventile vorgesehen sein. Eine unmittelbare Kopplung der Kälteträgerleitung der Flüssigkeitskühleinrichtung mit dem Kälterträgerkreislauf des zentralen Flugzeugflüssigkeitskühlsystems ermöglicht die Realisierung einer besonders einfach und kompakt aufgebauten, leichgewichtigen Kühleinrichtung. Alternativ dazu ist jedoch auch eine lediglich thermische Kopplung der Kälteträgerleitung der Flüssigkeitskühleinrichtung mit dem Kälterträgerkreislauf des zentralen Flugzeugflüssigkeitskühlsystems, beispielsweise über einen geeigneten Wärmetauscher denkbar. Eine derartige Anordnung bietet sich beispielsweise dann an, wenn in dem Kälterträgerkreislauf des zentralen Flugzeugflüssigkeitskühlsystems ein anderes Kälteträgermedium verwendet wird als in der Flüssigkeitskühleinrichtung des erfindungsgemäßen Flugzeugsignalrechnersystems.

Die von flüssigem Kälteträgermedium durchströmte Kälteträgerleitung der Flüssigkeitskühleinrichtung steht mit den modularen Signalrechnereinheiten in thermischem Oberflächenkontakt, um Wärme von den modularen Signalrechnereinheiten abzuführen. Bei dem erfindungsgemäßen Flugzeugsignalrechnersystem dient die Kälteträgerleitung der Flüssigkeitskühleinrichtung somit dazu, mehrere zu kühlende modulare Signalrechnereinheiten über deren Oberfläche mit der erforderlichen Kühlenergie zu versorgen. Beispielsweise kann die Kälteträgerleitung der Flüssigkeitskühleinrichtung thermisch mit einer Gehäuseoberfläche oder einem Gehäuseoberflächenabschnitt der zu kühlende modularen Signalrechnereinheiten gekoppelt sein. Bei dem erfindungsgemäßen Flugzeugsignalrechnersystem kann daher auf den einzelnen modularen Signalrechnereinheiten zugeordnete Cold Plates oder ähnliche Einrichtungen mit separaten Kühlmittelanschlüssen verzichtet werden.

Im Vergleich zu einer Luftkühlung ermöglicht die Flüssigkeitskühleinrichtung des erfindungsgemäßen Flugzeugsignalrechnersystems eine deutlich effizientere Wärmeabfuhr von den wärmeerzeugenden Komponenten der modularen Signalrechnereinheiten. Daher können die modularen Signalrechnereinheiten des erfindungsgemäßen Flugzeugsignalrechnersystems auf einem niedrigeren Temperaturniveau und folglich mit einer signifikant geringeren Ausfallwahrscheinlichkeit betrieben werden als luftgekühlte Einheiten. Darüber hinaus ermöglicht die hohe Kühlleistung der Flüssigkeitskühleinrichtung die Integration von leistungsstarken Elektronikbauteilen in kompakte Signalrechnereinheiten. Ein weiterer Vorteil des erfindungsgemäßen Flugzeugsignalrechnersystems besteht darin, dass die Flüssigkeitskühleinrichtung aufgrund des Verzichts auf den einzelnen modularen Signalrechnereinheiten zugeordnete Kühlanordnungen mit separaten Kühlmittelanschlüssen einen verhältnismäßig geringen Montage- und Wartungsaufwand erfordert. Ferner besteht bei der Flüssigkeitskühleinrichtung des erfindungsgemäßen Flugzeugsignalrechnersystems eine lediglich geringe Leckagegefahr. Schließlich wird ein in herkömmlichen Leistungselektronik-Flüssigkeitskühlsystemen durch Druckverluste an den Kühlmittelanschlüssen verursachter zusätzlicher Wärmeeintrag in das Gesamtsystem vermieden.

Die Flüssigkeitskühleinrichtung des erfindungsgemäßen Flugzeugsignalrechnersystems kann lediglich eine von flüssigem Kälteträgermedium durchströmte Kälteträgerleitung umfassen. Alternativ dazu kann die Flüssigkeitskühleinrichtung jedoch auch mehrere Kälteträgerleitungen aufweisen, die jeweils mit den mit den zu kühlenden modularen Signalrechnereinheiten in thermischem Oberflächenkontakt stehen. Mehrere Kälteträgerleitungen ermöglichen einen besonders effiziente Wärmeabfuhr von den zu kühlenden modularen Signalrechnereinheiten, erhöhen unter Umständen jedoch das Gewicht des Gesamtsystems. Daher kann es vorteilhaft sein, die Kälteträgerleitung(en) der Flüssigkeitskühleinrichtung beispielsweise in einen Träger zur Aufnahme der modularen Signalrechnereinheiten zu integrieren.

Die von flüssigem Kälteträgermedium durchströmte Kälteträgerleitung der Flüssigkeitskühleinrichtung kann über geeignete Wärmetauscher, beispielsweise im Bereich einer Gehäuseoberfläche der zu kühlenden modularen Signalrechnereinheiten angeordnete Oberflächenwärmetauscher, in thermischem Oberflächenkontakt mit den zu kühlenden modularen Signalrechnereinheiten stehen. Alternativ dazu kann die Kälteträgerleitung der Flüssigkeitskühleinrichtung jedoch auch in unmittelbarem thermischen Oberflächenkontakt mit den zu kühlenden modularen Signalrechnereinheiten stehen. Beispielsweise kann die Kälteträgerleitung in Form einer Kühlschiene ausgebildet sein, die an den Gehäusen der zu kühlenden modularen Signalrechnereinheiten entlanggeführt ist und mit den Gehäusen in unmittelbarem thermischen Oberflächenkontakt steht. Im Bereich der Kontaktflächen mit der Kälteträgerleitung der Flüssigkeitskühleinrichtung können die Gehäuse der zu kühlenden modularen Signalrechnereinheiten auch mit geeignet geformten Aussparungen versehen sein. Die Kälteträgerleitung der Flüssigkeitskühleinrichtung ist dann vorzugsweise so geführt, dass sie im Bereich der Aussparungen verläuft und dadurch einen Abschnitt der Gehäuse der zu kühlenden modularen Signalrechnereinheiten bildet.

Falls gewünscht, kann die Kälteträgerleitung der Flüssigkeitskühleinrichtung in gewichts- und einbauraumsparender Weise auch in einen Träger zur Aufnahme der modularen Signalrechnereinheiten integriert sein. Ferner kann die Kältetragerleitung kann eine Form haben, die geeignet ist, die Wärmeübertragung von den zu kühlenden modularen Signalrechnereinheiten auf das die Kältetragerleitung durchströmende Kälteträgermedium zu verbessern. Falls gewünscht oder erforderlich kann die Kälteträgerleitung beispielsweise spiralförmig ausgebildet sein oder eine anderweitig gewundene oder schlangenartige Form aufweisen, die geeignet ist, einen großflächigen Oberflächenkontakt mit den zu kühlenden modularen Signalrechnereinheiten zu ermöglichen.

Insbesondere dann, wenn die Kälteträgerleitung der Flüssigkeitskühleinrichtung besonders gewichts- und einbauraumsparend, beispielsweise in Form einer Kühlschiene ausgebildet ist und lediglich verhältnismäßig kleine Kontaktflächen zwischen der Kälteträgerleitung und den zu kühlenden modularen Signalrechnereinheiten vorhanden sind, kann es erforderlich sein, Maßnahmen zu ergreifen, die es ermöglichen, die Wärmestromdichte der Kontaktfläche zwischen der Kälteträgerleitung und den zu kühlenden modularen Signalrechnereinheiten und damit die Effizienz der Wärmeübertragung von den zu kühlenden modularen Signalrechnereinheiten auf die die Kälteträgerleitung der Flüssigkeitskühleinrichtung durchströmende Kälteträgerflüssigkeit zu erhöhen.

Zu diesem Zweck kann ein Wärmeleistung abgebendes Bauteil einer zu kühlenden modularen Signalrechnereinheit beispielsweise thermisch mit einem internen Wärmeleiter gekoppelt sein, der eine wärmeleitende Verbindung zwischen dem Wärmeleistung abgebenden Bauteil und der Kälteträgerleitung der Flüssigkeitskühleinrichtung herstellt. Beispielsweise kann ein erstes Ende des internen Wärmeleiters thermisch mit dem Wärmeleistung abgebenden Bauteil gekoppelt sein, während ein zweites Ende des internen Wärmeleiters mit einem Abschnitt einer Gehäuseoberfläche der zu kühlenden modularen Signalrechnereinheit thermisch gekoppelt sein kann, der seinerseits in thermischer Verbindung mit dem die Kälteträgerleitung der Flüssigkeitskühleinrichtung durchströmenden flüssigen Kälteträgermedium steht. Durch eine derartige Anordnung wird die Wärmeübertragung von dem Wärmeleistung abgebenden Bauteil auf das die Kälteträgerleitung der Flüssigkeitskühleinrichtung durchströmende Kälteträgermedium optimiert und intensiviert.

Das Wärmeleistung abgebende Bauteil der modularen Signalrechnereinheit kann zum Beispiel eine Platine sein. Als interner Wärmeleiter kann zum Beispiel eine konventionelle Heat Pipe zum Einsatz kommen. Falls gewünscht oder erforderlich können auch mehrere Wärmeleistung abgebende Bauteile der modularen Signalrechnereinheit mit Hilfe entsprechender interner Wärmeleiter thermisch mit der Kälteträgerleitung der Flüssigkeitskühleinrichtung gekoppelt sein. Ferner kann ein Wärmeleistung abgebendes Bauteil der modularen Signalrechnereinheit auch mit Hilfe mehrerer interner Wärmeleiter thermisch mit der Kälteträgerleitung der Flüssigkeitskühleinrichtung verbunden sein.

Für die thermische Kopplung des internen Wärmeleiters mit dem Wärmeleistung abgebenden Bauteil der modularen Signalrechnereinheit kann an dem Wärmeleistung abgebenden Bauteil eine entsprechende Schnittstelle vorgesehen sein. Zusätzlich oder alternativ dazu kann für die thermische Kopplung des internen Wärmeleiters mit der die Kälteträgerleitung der Flüssigkeitskühleinrichtung durchströmenden Kälteträgerflüssigkeit an einem Abschnitt eines Gehäuses der modularen Signalrechnereinheit, der in thermischem Oberflächenkontakt mit der die Kälteträgerleitung der Flüssigkeitskühleinrichtung durchströmenden Kälteträgerflüssigkeit steht, eine entsprechende Schnittstelle vorgesehen sein. Die Schnittstelle(n) kann/können plattenförmig ausgebildet sein und aus einem gut wärmeleitenden Material, wie zum Beispiel Kupfer oder Aluminium bestehen. Beispielsweise ist es denkbar, auf der Oberfläche einer ein Wärmeleistung abgebendes Bauteil bildenden Platine eine Schnittstelle in Form einer Platte aus einem gut wärmeleitenden Material vorzusehen und diese Schnittstelle thermisch mit dem ersten Ende des internen Wärmeleiters zu koppeln. In ähnlicher Weise kann in einen Abschnitt eines Gehäuses der modularen Signalrechnereinheit, der in thermischem Oberflächenkontakt mit der die Kälteträgerleitung der Flüssigkeitskühleinrichtung durchströmenden Kälteträgerflüssigkeit steht, eine Schnittstelle in Form einer Platte aus einem gut wärmeleitenden Material integriert sein, die thermisch mit dem zweiten Ende des internen Wärmeleiters gekoppelt werden kann. Der in thermischem Oberflächenkontakt mit der die Kälteträgerleitung der Flüssigkeitskühleinrichtung durchströmenden Kälteträgerflüssigkeit stehende Gehäuseabschnitt kann, wie oben beschrieben, auch durch einen Abschnitt der Kälteträgerleitung der Flüssigkeitskühleinrichtung gebildet sein, der sich im Bereich einer Gehäuseaussparung erstreckt.

An einem ersten und/oder einem zweiten Ende des internen Wärmeleiters kann eine Wärmetauscherfläche angeordnet sein. Beispielsweise können die Wärmetauscherflächen durch flächige Ausläufe des internen Wärmleiters gebildet werden, die aus einem gut wärmeleitenden Material, wie zum Beispiel Kupfer oder Aluminium bestehen. Gemeinsam mit einer an einem Wärmeleistung abgebenden Bauteil der modularen Signalrechnereinheit oder einem Gehäuseabschnitt der modularen Signalrechnereinheit vorgesehenen Schnittstelle bilden die Wärmetauscherflächen des internen Wärmeleiters einen Kontaktwärmetauscher, der einen optimierten Wärmetransfer von dem Wärmeleistung abgebenden Bauteil der modularen Signalrechnereinheit auf den internen Wärmeleiter bzw. von dem internen Wärmeleiter auf den Gehäuseabschnitt der modularen Signalrechnereinheit und folglich auf die die Kälteträgerleitung der Flüssigkeitskühleinrichtung durchströmende Kälteträgerflüssigkeit ermöglicht.

Das Wärmeleistung abgebende Bauteil der modularen Signalrechnereinheit steht mit einem Kälteträgerbad in thermischem Kontakt, das seinerseits mit der Kälteträgerleitung der Flüssigkeitskühleinrichtung thermisch gekoppelt ist. Beispielsweise kann ein Gehäuse oder ein Gehäuseabschnitt der modularen Signalrechnereinheit fluiddicht ausgebildet und zur Aufnahme eines Kälteträgermediums vorgesehen sein, das zum Beispiel mittels eines geeigneten Wärmetauschers in thermischem Kontakt mit dem Wärmeleistung abgebenden Bauteil der modularen Signalrechnereinheit steht, um Wärme von dem Wärmeleistung abgebenden Bauteil abzuführen.

Alternativ dazu kann das Wärmeleistung abgebende Bauteil auch teilweise oder vollständig in ein in einem Gehäuse oder einem Gehäuseabschnitt der modularen Signalrechnereinheit angeordnetes Kälteträgerbad eintauchen, so dass das Wärmeleistung abgebende Bauteil der modularen Signalrechnereinheit vollständig oder teilweise von dem Kälteträgermedium des Kälteträgerbads umgeben ist.

Die thermische Kopplung zwischen dem Kälteträgerbad und der von flüssigem Kälteträgermedium durchströmten Kälteträger!eitung der Flüssigkeitskühleinrichtung kann über einen Abschnitt des Gehäuses der modularen Signalrechnereinheit hergestellt werden, der von dem die Kälteträgerleitung der Flüssigkeitskühleinrichtung durchströmenden Kälteträgermedium gekühlt wird. Dieser Gehäuseabschnitt kann dazu eingerichtet sein, eine Kondensationsfläche zu bilden, an der durch die Wärmeleistung des Bauteils der modularen Signalrechnereinheit aus dem Kälteträgerbad verdampftes Kälteträgermedium unter Wärmeentzug kondensiert. Im Betrieb einer derartigen Anordnung verdampft flüssiges Kälteträgermedium aus dem Kälteträgerbad aufgrund des Wärmetransfers von dem Wärmeleistung abgebenden Bauteil auf das Kälteträgermedium, so dass das Wärmeleistung abgebende Bauteil durch die bei der Verdampfung des Kälteträgermediums freiwerdende Kühlenergie auf besonders effektive Weise gekühlt werden kann. Um eine ordnungsgemäße Funktion einer derartigen 2-Phasen-Kühlung zu gewährleisten, muss ein Kälteträgermedium eingesetzt werden, dessen Verdampfungstemperatur innerhalb eines gewünschten Kühltemperaturbereichs des Wärmeleistung abgebenden Bauteils liegt. Das aus dem Kälteträgerbad verdampfte Kälteträgermedium wird an der Kondensationsfläche wieder in den flüssigen Aggregatzustand zurückversetzt und tropft verlustfrei in das Kälteträgerbad zurück.

Das Wärmeleistung abgebende Bauteil der modularen Signalrechnereinheit steht mit einem Substrat in thermischem Kontakt, das aufgrund seiner Kapillarwirkung dazu eingerichtet ist, Kälteträgermedium aus dem Kälteträgerbad entlang einer Oberfläche des Bauteils zu leiten. Das Substrat ist vorzugsweise so geformt und angeordnet, dass es zumindest einen Teil der Oberfläche des Wärmeleistung abgebenden Bauteils bedeckt. Durch den Einsatz eines Substrats als "Leitmedium" für das Kälteträgermedium aus dem Kälteträgerbad muss das Wärmeleistung abgebende Bauteil nicht mehr großflächig oder vollständig in das Kälteträgerbad eintauchen, um den für eine ordnungsgemäße Kühlung erforderlichen großflächigen Kontakt mit dem Kälteträgermedium aus dem Kälteträgerbad zu haben. Das Kälteträgermedium aus dem Kälteträgerbad kann die Kapillaren des Substrats in flüssigem Zustand durchströmen. Eine besonders effiziente Kühlung des Wärmeleistung abgebenden Bauteils ist jedoch dann möglich, wenn das Kälteträgermedium beim Durchströmen der Kapillaren des Substrats durch den Wärmetransfer von dem Wärmeleistung abgebenden Bauteil verdampft. Zur Kondensation von verdampftem Kälteträgermedium kann wiederum eine Kondensationsfläche vorgesehen sein, die in thermischem Oberflächenkontakt mit dem die Kälteträgerleitung der Flüssigkeitskühleinrichtung durchströmenden Kälteträgermedium steht.

Um für die gewünschte Kapillarwirkung zu sorgen kann das Substrat aus einem porösen Material bestehen. Beispielsweise kann das Substrat aus einem keramischen Sintermaterial, einem Textilmaterial oder einem Geflechtmaterial bestehen.

Das erfindungsgemäße Flugzeugsignalrechnersystem wird im Folgenden unter Bezugnahme auf die beigefügten schematischen Figuren detailliert erläutert. Es zeigen:
- Figur 1: ein Flugzeugsignalrechnersystem mit einer Mehrzahl von modularen Signalrechnereinheiten und einer Flüssigkeitskühleinrichtung zur Kühlung der modularen Signalrechnereinheiten;
- Figur 2: eine erste Ausgestaltung einer modularen Signalrechnereinheit gemäß Figur 1;
- Figur 3: eine zweite Ausgestaltung einer modularen Signalrechnereinheit gemäß Figur 1;
- Figur 4: eine dritte Ausgestaltung einer modularen Signalrechnereinheit gemäß Figur 1.

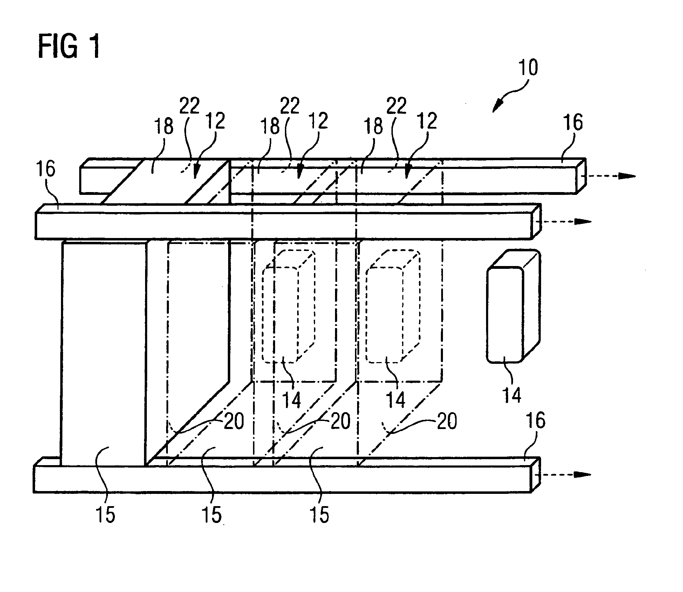

Figur 1 zeigt ein zum Einsatz in einem Verkehrsflugzeug vorgesehenes Flugzeugsignalrechnersystem 10, das eine Mehrzahl von modularen Signalrechnereinheiten 12 umfasst. Jede modulare Signalrechnereinheit 12 kann über einen Steckkontakt 14, der zu eingerichtet ist, mit einem an einem Gehäuse 15 der modularen Signalrechnereinheit 12 ausgebildeten komplementären Steckkontakt zusammenzuwirken, mit einem elektronischen System des Flugzeugs verbunden werden. Durch die Verbindung der Steckkontakte wird die modulare Signalrechnereinheit 12 lösbar in ihrer Position in dem Flugzeugsignalrechnersystem 10 fixiert. Bei Bedarf, beispielsweise bei der Durchführung von Wartungsarbeiten, kann die modulare Signalrechnereinheit 12 somit wieder aus ihrem Steckplatz in dem Flugzeugsignalrechnersystem 10 entfernt werden.

Das Flugzeugsignalrechnersystem 10 umfasst ferner eine Flüssigkeitskühleinrichtung zum Kühlen der modularen Signalrechnereinheiten 12. Die Flüssigkeitskühleinrichtung weist mindestens eine Kälteträgerleitung 16 auf, die mit einem zentralen Flüssigkeitskühlsystem eines Flugzeugs verbindbar ist, um der Flüssigkeitskühleinrichtung ein flüssiges Kälteträgermedium mit einer gewünschten tiefen Temperatur zuzuführen. Die Flüssigkeitskühleinrichtung muss somit nicht mit einer separaten Kältemaschine versehen sein, sondern kann von dem zentralen Flüssigkeitskühlsystem des Flugzeugs mit Kühlenergie versorgt werden. In dem in Fig. 1 gezeigten Ausführungsbeispiel sind drei beispielhafte Anordnungen einer in Form einer Kühlschiene ausgebildeten und in unmittelbarem thermischen Oberflächenkontakt mit den zu kühlenden modularen Signalrechnereinheiten 12 stehenden Kälteträgerleitung 16 gezeigt. Die Flüssigkeitskühleinrichtung kann lediglich eine Kälteträgerleitung 16 umfassen. Falls gewünscht oder erforderlich können jedoch auch mehrere Kälteträgerleitungen 16 vorhanden sein.

Die in Fig. 1 dargestellten Kälteträgerleitungen 16 haben jeweils einen quadratischen Querschnitt. Dies ermöglicht es, eine Kontaktfläche zwischen einer Kälteträgerleitung 16 und einem Oberflächenabschnitt des Gehäuses 15 einer zu kühlenden modularen Signalrechnereinheit 12 zu vergrößern und dadurch für eine optimierte Wärmeübertragung von der zu kühlenden modularen Signalrechnereinheit 12 auf die die Kälteträgerleitung 16 durchströmende Kälteträgerflüssigkeit zu sorgen. Falls gewünscht oder erforderlich können die Kälteträgerleitungen 16 jedoch auch einen beliebigen anderen Querschnitt aufweisen. Ferner erstrecken sich die Kälteträgerleitungen 16 entlang von Seitenwänden 18, 20 und/oder von Rückwänden 22 der Gehäuse 15 der zu kühlenden modularen Signalrechnereinheiten 12, so dass sie die Montage sowie die Demontage der modularen Signalrechnereinheiten 12 nicht behindern.

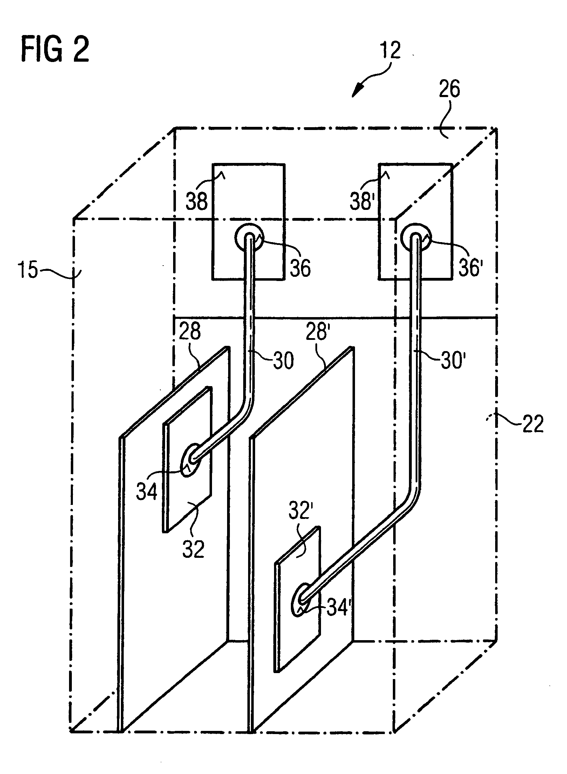

Die Figuren 2 bis 4 zeigen drei verschiedene Ausgestaltungen einer modularen Signalrechnereinheit 12, die eine optimierte Wärmeübertragung von der modularen Signalrechnereinheit 12 auf die eine Kälteträgerleitung 16 der Flüssigkeitskühleinrichtung durchströmende Kälteträgerflüssigkeit ermöglichen.

Bei der in Figur 2 dargestellten modulare Signalrechnereinheit 12 ist das Gehäuse 15 der modularen Signalrechnereinheit 12 im Bereich seiner Rückenwand 22 mit einer Aussparung versehen. Im Bereich dieser Aussparung erstreckt sich ein Abschnitt 26 der in Figur 1 gezeigten Kälteträgerleitung 16 der Flüssigkeitskühleinrichtung und bildet damit einen integralen Bestandteil des Gehäuses 15. In dem Gehäuse 15 der modularen Signalrechnereinheit 12 sind zwei in Form von mit elektronischen Komponenten bestückten Platinen ausgebildete Bauteile 28, 28' angeordnet, die Wärmeleistung abgeben.

Die Bauteile 28, 28' sind jeweils thermisch mit einem internen Wärmeleiter 30, 30' gekoppelt. Zu diesem Zweck ist an den Bauteilen 28, 28' jeweils eine plattenförmig ausgebildete Schnittstelle 32, 32' vorgesehen. Die Schnittstellen 32, 32' sind jeweils mit einer ersten Wärmetauscherfläche 34, 34' verbunden, die an einem ersten Ende der internen Wärmeleiter 30, 30' angeordnet ist. An einem zweiten Ende der internen Wärmeleiter 30, 30' sind zweite Wärmetauscherflächen 36, 36' angeordnet. Die zweiten Wärmetauscherflächen 36, 36' sind jeweils mit einer plattenförmig ausgebildeten Schnittstelle 38, 38' verbunden, die an dem Abschnitt 26 der Kälteträgerleitung 16 vorgesehen ist. Die Schnittstellen 32, 32', 38, 38', die ersten Wärmetauscherflächen 34, 34' und die zweiten Wärmetauscherflächen 36, 36' bestehen jeweils aus einem thermisch leitenden Material, wie beispielsweise Aluminium oder Kupfer.

Die internen Wärmeleiter 30, 30' umfassen Heat Pipes, die rohrförmig ausgebildet und an ihren Enden mit einem thermisch leitenden Material fluiddicht abgedichtet sind. In den Heat Pipes ist eine Kapillarstruktur ausgebildet, die zum Beispiel durch ein Kupferdrahtgeflecht erzeugt werden kann. Ferner ist in den Heat Pipes eine Flüssigkeit aufgenommen, deren Verdampfungstemperatur innerhalb des gewünschten Kühltemperaturbereichs der Bauteile 28, 28' liegt. Durch die von den Bauteilen 28, 28' erzeugte Abwärme verdampft zumindest ein Teil der in den Heat Pipes enthaltenen Flüssigkeit und wird durch die Kapillarstruktur der Heat Pipes nach dem Dochtprinzip in Richtung des thermisch mit der Kälteträgerleitung 16 gekoppelten Endes der Heat Pipes geleitet, wo die Flüssigkeit wieder kondensiert und in der Kapillarstruktur der Heat Pipes in Richtung der Wärmleistung abgebenden Bauteile 28, 28' zurückfließt.

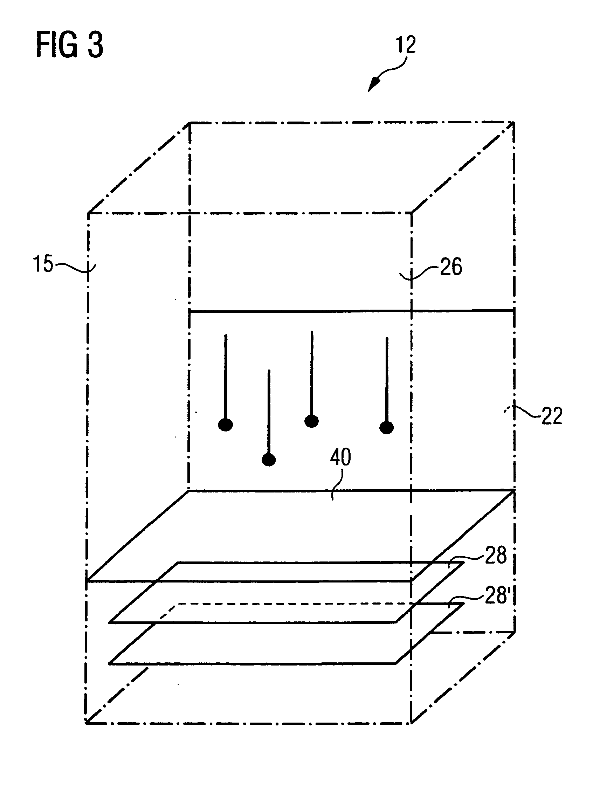

Bei der in Figur 3 gezeigten modularen Signalrechnereinheit ist das Gehäuse 15 fluiddicht ausgestaltet und dient der Aufnahme eines Kälteträgerbads 40. Die zu kühlenden Bauteile 28, 28' sind so in dem Gehäuse 15 angeordnet, dass sie vollständig von dem inerten und nicht elektrisch leitenden Kälteträgermedium des Kälteträgerbads 40 bedeckt sind. Die Verdampfungstemperatur des Kälteträgermediums des Kälteträgerbades 40 liegt innerhalb des gewünschten Kühltemperaturbereichs der Wärmeleistung abgebenden Bauteile 28, 28'. Durch die abgegebene Wärmeleistung der Bauteile 28, 28' verdampft das Kälteträgermedium aus dem Kälteträgerbad 40. An dem durch den Abschnitt 26 der Kälteträgerleitung 16 der Flüssigkeitskühleinrichtung gebildeten Gehäuseabschnitt kondensiert die verdampfte Flüssigkeit unter Entzug von Wärmeenergie und fließt an der Rückwand 22 des Gehäuses 15 zurück in das Kälteträgerbad 40. Die Kühlung der Wärmeleistung abgebenden Bauteile 28, 28' wird hier durch direktes Verdampfen von Flüssigkeit aus dem Kälteträgerbad 40 erzielt.

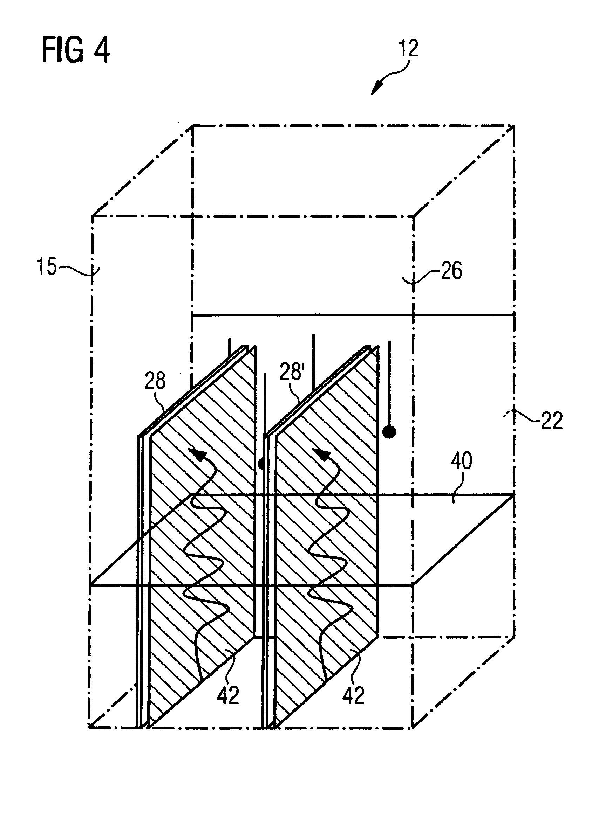

Bei der in Figur 4 veranschaulichten modularen Signalrechnereinheit ist das Gehäuse 15 ebenfalls fluiddicht ausgestaltet und nimmt ein Kälteträgerbad 40 auf. Die zu kühlenden Bauteile 28, 28' sind jedoch lediglich teilweise von dem Kälteträgermedium des Kälteträgerbads 40 bedeckt. Auf die Oberflächen der Bauteile 28, 28' sind jeweils ein Substrat 42 aufgebracht. Die Struktur der Substrate 42 erzeugt eine Kapillarwirkung. Beispielsweise können die Substrate 42 aus einem Sintermaterial, einem Textilmaterial oder einem Metallgeflecht geformt sein.

Durch die Kapillarwirkung der Substrate 42 steigt Kälteträgermedium aus dem Kälteträgerbad 40 auf und fließt entlang der Oberflächen der Bauteile 28, 28'. Durch die abgegebene Wärmeleistung der Bauteile 28, 28' verdampft das flüssige Kälteträgermedium und kühlt dabei die Bauteile 28, 28'. Schließlich kondensiert das verdampfte Kälteträgermedium aus dem Kälteträgerbad 40, ähnlich wie bei der Anordnung gemäß Figur 3, an dem Abschnitt 26 der Kälteträgerleitung 16 unter Entzug von Wärmeenergie und fließt an der Rückwand 22 des Gehäuses 15 zurück in das Kälteträgerbad 40.

## Patentansprüche

1. Flugzeugsignalrechnersystem (10) mit:
- einer Mehrzahl von modularen Signalrechnereinheiten (12), die jeweils in einem Gehäuse (15) angeordnet sind, und
- einer Flüssigkeitskühleinrichtung zum Kühlen der modularen Signalrechnereinheiten (12), wobei die Flüssigkeitskühleinrichtung eine Kälteträgerleitung (16) umfasst, die mit einem zentralen Flüssigkeitskühlsystem eines Flugzeugs verbindbar ist, um der Flüssigkeitskühleinrichtung ein flüssiges Kälteträgermedium mit einer gewünschten tiefen Temperatur zuzuführen, und wobei die Kälteträgerleitung (16) der Flüssigkeitskühleinrichtung mit Außenflächen oder Außenflächenabschnitten der Gehäuse (15) der modularen Signalrechnereinheiten (12) in thermischem Oberflächenkontakt steht, um Wärme von den modularen Signalrechnereinheiten (12) abzuführen,
**dadurch gekennzeichnet, dass** ein Wärmeleistung abgebendes Bauteil (28, 28') einer modularen Signalrechnereinheit (12) mit einem Kälteträgerbad (40) in thermischem Kontakt steht, das seinerseits mit der Kälteträgerleitung (16) der Flüssigkeitskühleinrichtung thermisch gekoppelt ist, wobei das Wärmeleistung abgebende Bauteil (28, 28') der modularen Signalrechnereinheit (12) mit einem Substrat (42) in thermischem Kontakt steht, das auf Grund seiner Kapillarwirkung dazu eingerichtet ist, Kälteträgermedium aus dem Kälteträgerbad (40) entlang einer Oberfläche des Bauteils (28, 28') zu leiten.

2. Flugzeugsignalrechnersystem nach Anspruch 1,
**dadurch gekennzeichnet, dass** die Kälteträgerleitung (16) der Flüssigkeitskühleinrichtung in unmittelbarem thermischen Oberflächenkontakt mit Außenflächen oder Au-βenflächenabschnitten der Gehäuse (15) der zu kühlenden modularen Signalrechnereinheiten (12) steht.

3. Flugzeugsignalrechnersystem nach Anspruch 1,
**dadurch gekennzeichnet, dass** ein Wärmeleistung abgebendes Bauteil (28, 28') einer modularen Signalrechnereinheit (12) thermisch mit einem internen Wärmeleiter; (30, 30') gekoppelt ist, der eine wärmeleitende Verbindung zwischen dem Wärmeleistung abgebenden Bauteil (28, 28') und der Kälteträgerleitung (16) der Flüssigkeitskühleinrichtung herstellt.

4. Flugzeugsignalrechnersystem nach Anspruch 3,
**dadurch gekennzeichnet, dass** für die thermische Kopplung des internen Wärmeleiters (30, 30') mit dem Wärmeleistung abgebenden Bauteil (28, 28') der modularen Signalrechnereinheit (12) an dem Wärmeleistung abgebenden Bauteil (28, 28') eine entsprechende Schnittstelle (32, 32') vorgesehen ist und/oder dass für die thermische Kopplung des internen Wärmeleiters (30, 30') mit dem die Kälteträgerleitung (16) der Flüssigkeitskühleinrichtung durchströmenden Kälteträgermedium an einem Abschnitt (26) eines Gehäuses (15) der modularen Signalrechnereinheit (12) eine entsprechende Schnittstelle (36, 36') vorgesehen ist.

5. Flugzeugsignalrechnersystem nach Anspruch 3 oder 4,
**dadurch gekennzeichnet, dass** an einem ersten und/oder einem zweiten Ende des internen Wärmeleiters (30, 30') eine Wärmetauscherfläche (34, 34') angeordnet ist.

6. Flugzeugsignalrechnersystem nach einem der Ansprüche 1 bis 5,
**dadurch gekennzeichnet, dass** das Wärmeleistung abgebende Bauteil (28, 28') der modularen Signalrechnereinheit (12) in das Kälteträgerbad (40) eintaucht, so dass es teilweise oder vollständig von dem Kälteträgermedium des Kälteträgerbads (40) umgeben ist.

7. Flugzeugsignalrechnersystem nach einem der Ansprüche 1 bis 6,
**dadurch gekennzeichnet, dass** die thermische Kopplung zwischen dem Kälteträgerbad (40) und der Kälteträgerleitung (16) der Flüssigkeitskühleinrichtung über einen Abschnitt (26) eines Gehäuses (15) der modularen Signalrechnereinheit (12) hergestellt wird, der von dem die Kälteträgerleitung (16) der Flüssigkeitskühleinrichtung durchströmenden Kälteträgermedium gekühlt wird und der dazu eingerichtet ist, eine Kondensationsfläche zu bilden, an der durch die Wärmeleistung des Bauteils (28, 28') der modularen Signalrechnereinheit (12) aus dem Kälteträgerbad (40) verdampftes Kälteträgermedium unter Wärmeentzug kondensiert.

8. Flugzeugsignalrechnersystem nach einem der Ansprüche 1 bis 7,
**dadurch gekennzeichnet, dass** das Substrat (42) aus einem porösen Material gefertigt ist.

## Claims

1. Aircraft signal computer system (10) having:
- a plurality of modular signal computer units (12) which are each arranged in a housing (15), and
- a liquid cooling device for cooling the modular signal computer units (12), the liquid cooling device comprising a coolant line (16), which is connectable to a central liquid cooling system of an aircraft in order to supply a liquid coolant medium at a desired low temperature to the liquid cooling device, and the coolant line (16) of the liquid cooling device being in thermal surface contact with outer surfaces or outer surface sections of the housings (15) of the modular signal computer units (12) in order to dissipate heat from the modular signal computer units (12),
**characterised in that** a heat-emitting component (28, 28') of a modular signal computer unit (12) is in thermal contact with a coolant bath (40) which is thermally coupled to the coolant line (16) of the liquid cooling device, the heat-emitting component (28, 28') of the modular signal computer unit (12) being in thermal contact with a substrate (42) which on account of its capillary action is designed to conduct coolant medium from the coolant bath (40) along a surface of the component (28, 28').

2. Aircraft signal computer system according to Claim 1,
**characterised in that** the coolant line (16) of the liquid cooling device is in direct thermal surface contact with outer surfaces or outer surface sections of the housings (15) of the modular signal computer units (12) to be cooled.

3. Aircraft signal computer system according to Claim 1,
**characterised in that** a heat-emitting component (28, 28') of a modular signal computer unit (12) is thermally coupled to an internal heat conductor (30, 30') which establishes a heat-conducting connection between the heat-emitting component (28, 28') and the coolant line (16) of the liquid cooling device.

4. Aircraft signal computer system according to Claim 3,
**characterised in that** for the thermal coupling of the internal heat conductor (30, 30') to the heat-emitting component (28, 28') of the modular signal computer unit (12) a corresponding interface (32, 32') is provided on the heat-emitting component (28, 28') and/or **in that** for the thermal coupling of the internal heat conductor (30, 30') to the coolant medium flowing through the coolant line (16) of the liquid cooling device a corresponding interface (36, 36') is provided on a section (26) of a housing (15) of the modular signal computer unit (12).

5. Aircraft signal computer system according to Claim 3 or 4,
**characterised in that** a heat exchanger surface (34, 34') is arranged at a first and/or a second end of the internal heat conductor (30, 30').

6. Aircraft signal computer system according to one of Claims 1 to 5,
**characterised in that** the heat-emitting component (28, 28') of the modular signal computer unit (12) is immersed in the coolant bath (40) so that it is partially or completely surrounded by the coolant medium of the coolant bath (40).

7. Aircraft signal computer system according to one of Claims 1 to 6,
**characterised in that** the thermal coupling between the coolant bath (40) and the coolant line (16) of the liquid cooling device is established via a section (26) of a housing (15) of the modular signal computer unit (12), which section is cooled by the coolant medium flowing through the coolant line (16) of the liquid cooling device and is designed to form a condensation surface on which coolant medium, evaporated from the coolant bath (40) by the heat emission of the component (28, 28') of the modular signal computer unit (12), condenses with heat abstraction.

8. Aircraft signal computer system according to one of Claims 1 to 7,
**characterised in that** the substrate (42) is produced from a porous material.

## Revendications

1. Système de calculateur de signaux (10) pour avion, comprenant :
- une pluralité d'unités modulaires de calculateur de signaux (12) qui sont agencées respectivement dans un boitier (15), et
- un dispositif de refroidissement à liquide pour refroidir des unités modulaires de calculateur de signaux (12), le dispositif de refroidissement à liquide comprenant une conduite de caloporteur (16) apte à être reliée à un système centralisé de refroidissement à liquide d'un avion, en vue d'alimenter le dispositif de refroidissement à liquide avec un agent caloporteur liquide se trouvant à une température basse choisie, et la conduite de caloporteur (16) du dispositif de refroidissement à liquide étant en contact thermique superficiel avec des surfaces extérieures ou des tronçons de surface extérieure des boitiers (15) des unités modulaires de calculateur de signaux (12), en vue d'évacuer de la chaleur des unités modulaires de calculateur de signaux (12),
**caractérisé en ce qu'**un composant exothermique (28, 28') d'une unité modulaire de calculateur de signaux (12) est en contact thermique avec un bain de caloporteur (40), qui pour sa part est couplé thermiquement à la conduite de caloporteur (16) du dispositif de refroidissement à liquide, le composant exothermique (28, 28') de l'unité modulaire de calculateur de signaux (12) étant en contact thermique avec un substrat (42) qui, en raison de sa capillarité, est adapté pour diriger de l'agent caloporteur liquide du bain de caloporteur (40) le long d'une surface dudit composant (28, 28').

2. Système de calculateur de signaux pour avion selon la revendication 1,
**caractérisé en ce que** la conduite de caloporteur (16) du dispositif de refroidissement à liquide est en contact thermique superficiel direct avec des surfaces extérieures ou des tronçons de surface extérieure des boitiers (15) des unités modulaires de calculateur de signaux (12) à refroidir.

3. Système de calculateur de signaux pour avion selon la revendication 1,
**caractérisé en ce qu'**un composant exothermique (28, 28') d'une unité modulaire de calculateur de signaux (12) est couplée thermiquement avec un conducteur de chaleur (30, 30') interne qui réalise un contact thermique entre le composant exothermique (28, 28') et la conduite de caloporteur (16) du dispositif de refroidissement à liquide.

4. Système de calculateur de signaux pour avion selon la revendication 3,
**caractérisé en ce que** pour le couplage thermique du conducteur de chaleur (30, 30') interne avec le composant exothermique (28, 28') de l'unité modulaire de calculateur de signaux (12), il est prévu une interface (32, 32') appropriée sur le composant exothermique (28, 28'), et/ou **en ce que** pour le couplage thermique du conducteur de chaleur (30, 30') interne avec l'agent caloporteur s'écoulant à travers la conduite de caloporteur (16) du dispositif de refroidissement à liquide, il est prévu une interface (36, 36') appropriée sur un tronçon (26) d'un boitier (15) de l'unité modulaire de calculateur de signaux (12).

5. Système de calculateur de signaux pour avion selon la revendication 3 ou la revendication 4,
**caractérisé en ce qu'**une surface d'échange thermique (34, 34') est agencée à une première et/ou à une deuxième extrémité du conducteur de chaleur (30, 30') interne.

6. Système de calculateur de signaux pour avion selon l'une des revendications 1 à 5,
**caractérisé en ce que** le composant exothermique (28, 28') de l'unité modulaire de calculateur de signaux (12) plonge dans le bain de caloporteur (40), de sorte qu'il est entouré partiellement ou totalement par l'agent caloporteur du bain de caloporteur (40).

7. Système de calculateur de signaux pour avion selon l'une des revendications 1 à 6,
**caractérisé en ce que** le couplage thermique entre le bain de caloporteur (40) et la conduite de caloporteur (16) du dispositif de refroidissement à liquide est établi par l'intermédiaire d'un tronçon (26) d'un boitier (15) de l'unité modulaire de calculateur de signaux (12). qui est refroidi par l'agent caloporteur s'écoulant à travers la conduite de caloporteur (16) du dispositif de refroidissement à liquide et qui est adapté pour former une surface de condensation sur laquelle condense, par évacuation de chaleur, de l'agent caloporteur évaporé du bain de caloporteur (40) sous l'effet de la puissance thermique dissipée par le composant (28, 28') de l'unité modulaire de calculateur de signaux (12).

8. Système de calculateur de signaux pour avion selon l'une des revendications 1 à 7,
**caractérisé en ce que** le substrat (42) est réalisé en un matériau poreux.
